(19) Europäisches Patentamt
European Patent Office
Office européen des brevets

(11) **EP 2 144 222 B1**

(12) **EUROPEAN PATENT SPECIFICATION**

(45) Date of publication and mention
of the grant of the patent:
**13.03.2013 Bulletin 2013/11**

(51) Int Cl.:
***G09G 3/32*** *(2006.01)*

(21) Application number: **09162672.1**

(22) Date of filing: **15.06.2009**

(54) **Light emitting diode display device**

Leuchtdiodenanzeigevorrichtung

Dispositif d'affichage à diodes électroluminescentes

(84) Designated Contracting States:
**AT BE BG CH CY CZ DE DK EE ES FI FR GB GR HR HU IE IS IT LI LT LU LV MC MK MT NL NO PL PT RO SE SI SK TR**

(30) Priority: **10.07.2008 KR 20080067133**

(43) Date of publication of application:
**13.01.2010 Bulletin 2010/02**

(73) Proprietor: **LG Display Co., Ltd.**
**Youngdungpo-gu,**
**Seoul (KR)**

(72) Inventors:
• **Kwon, Yong-Il**
**Gumi-si (KR)**
• **Woo, Kyoung-Don**
**Gumi-si (KR)**
• **Lee, Jae-Do**
**Gumi-si, Gyeongbuk (KR)**

(74) Representative: **Viering, Jentschura & Partner**
**Am Brauhaus 8**
**01099 Dresden (DE)**

(56) References cited:
**US-A1- 2004 061 671**   **US-A1- 2004 257 353**
**US-A1- 2005 212 444**   **US-A1- 2007 008 269**

**Description**

**BACKGROUND OF THE DISCLOSURE**

**Field of the Disclosure**

The present invention relates to, light emitting diode display devices, and, more particularly, to a light emitting diode display device which can prevent a drive switching device from degrading.

**Discussion of the Related Art**

Currently, various flat display devices are under developing, which has weight and volume smaller than a cathode ray tube, and especially, the light emitting display device having excellent light emitting efficiency, brightness and an angle of view, and a fast responsive speed, is paid attention.

A light emitting device has a structure in which a light emitting layer which is a light emitting thin film disposed between a cathode and an anode for injecting an electron and a hole into the light emitting layer to make the electron and the hole to recombine, which causes generation of an exciter that emits a light as the exciter drops to a lower energy level.

The light emitting layer of the light emitting device is formed of inorganic or organic material, and depending on the material of the light emitting layer, the light emitting device is called either as an inorganic light emitting device, or an organic light emitting device.

A drive switching device controls an intensity of a driving current to the light emitting device. That is, the drive switching device controls the intensity of the driving current in response to a data signal from a gate electrode for the drive switching device. However, since the data signal always has a positive polarity or a negative polarity, keeping a threshold voltage of the drive switching device to increase in one direction as a drive time period of the drive switching device increases, there has been a problem in that the drive switching device is degraded.

Document US 2004/257353 A1 discloses a light emitting diode display device, comprising: a plurality of pixel cells, each having a light emitting diode; a plurality of data lines for transmission of a data signal having information on a picture; a plurality of gate lines for transmission of a gate signal, wherein each of the pixel cells includes: a signal transmission switching device for connecting the data line to a node according to the first gate high voltage from the gate line, a drive switching device for controlling an intensity of a drive current being supplied to the light emitting diode according to a signal state of the node, a storage capacitor connected between the node and a source electrode or a drain electrode of the drive switching device, and a control switching device for connecting the gate line to the node.

**SUMMARY OF THE DISCLOSURE**

Accordingly, the present invention is directed to a light emitting diode display device.

An object of the present invention is to provide a light emitting diode display device, in which a voltage having a polarity opposite to a data signal is supplied to a gate electrode for a drive switching device periodically for restoring a threshold voltage of the drive switching device to an original value to prevent the drive switching device from degrading.

Additional advantages, objects, and features of the disclosure will be set forth in part in the description which follows and in part will become apparent to those having ordinary skill in the art upon examination of the following or may be learned from practice of the invention. The objectives and other advantages of the invention may be realized and attained by the structure particularly pointed out in the written description and claims hereof as well as the appended drawings.

To achieve these objects and other advantages and in accordance with the purpose of the invention, as embodied and broadly described herein, a light emitting diode display device includes according to claim 1 is provided. Further embodiments of the invention are described in the dependent claims.

It is to be understood that both the foregoing general description and the following detailed description of the present invention are exemplary and explanatory and are intended to provide further explanation of the invention as claimed.

**BRIEF DESCRIPTION OF THE DRAWINGS**

The accompanying drawings, which are included to provide a further understanding of the disclosure and are incorporated in and constitute a part of this application, illustrate embodiment(s) of the disclosure and together with the description serve to explain the principle of the disclosure. In the drawings:

FIG. 1 illustrates a diagram of a light emitting display device in accordance with a preferred embodiment of the present invention.

FIG. 2 illustrates a diagram of waveforms of various signals supplied to the light emitting diode in FIG. 1.

FIG. 3 illustrates a diagram of a circuit of a pixel cell in FIG. 1.

FIG. 4 illustrates a system diagram of a gate driver in accordance with a first preferred embodiment of the present invention.

FIG. 5 illustrates a system diagram of a gate driver in accordance with a second preferred embodiment of the present invention.

*Description of symbols on key parts in the drawings*

| | |
|---|---|
| Tr_T: signal transmission switching device | |
| Tr_D: drive switching device | Tr_C: control switching device |
| n: node | DL: data line |
| GL: gate line | Cst: storage capacitor |
| VDD: first driving power source | |
| VSS: second driving power source | |
| OLED: light emitting device | Data: data signal |
| CS: control signal | GS: gate signal |

## DESCRIPTION OF SPECIFIC EMBODIMENTS

Reference will now be made in detail to the specific embodiments of the present invention, examples of which are illustrated in the accompanying drawings. Wherever possible, the same reference numbers will be used throughout the drawings to refer to the same or like parts.

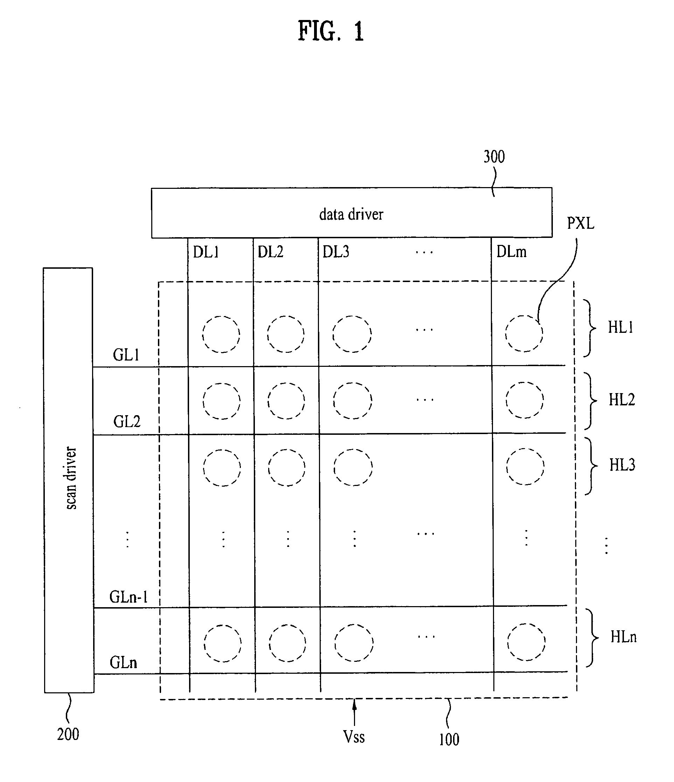

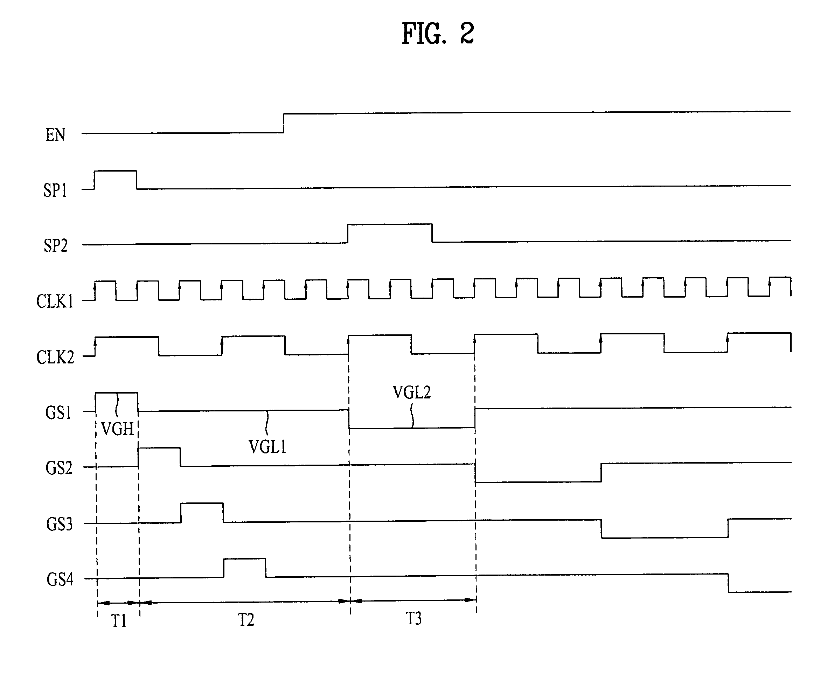

FIG. 1 illustrates a diagram of a light emitting display device in accordance with a preferred embodiment of the present invention, and FIG. 2 illustrates a diagram of waveforms of various signals supplied to the light emitting diode in FIG. 1.

Referring to FIG. 1, the light emitting display device includes m (m is a natural numeral) data lines DL1 ~ DLm for applying a data signal thereto, n (n is a natural numeral different from m) gate lines GL1 ~ GLn for applying a gate signal thereto, a first drive power line (not shown) for supplying first power VDD therethrough, a second drive power line (not shown) for supplying second power VSS therethrough, a display unit 100 having a plurality of pixel cells PXL, a gate driver 200 for driving the gate lines GL1 ~ GLn, and a data driver 300 for supplying a data signal data having information on a picture to the data lines DL1 ~ DLm.

The gate driver 200 generates gate signals GS1 ~ GSn by using start pulses SP1 and SP2 and clock signals CLK1 and CLK2 and supplies the gate signals GS1 ~ GSn to the gate lines GL1 ~ GLn respectively. As shown in FIG. 2, the gate signals GS1 ~ GSn respectively supplied to the gate lines GL1 ~ GLn have a gate high voltage VGH, a first gate low voltage VGL1 and a second gate low voltage VGL2. The gate high voltage VGH, the first gate low voltage VGL1 and the second gate low voltage VGL2 have potentials different from one another. That is, the first gate low voltage VGL1 has a potential lower than the gate high voltage and the second gate low voltage VGL2 has a potential lower than the first gate low voltage VGL1. Particularly, the second gate low voltage VGL2 has a polarity opposite to a polarity of the data signal. In this instance, as described before, since the data signal Data has a positive polarity, the second gate low voltage VGL2 has a negative polarity. If the data signal Data has a negative polarity, the second gate low voltage VGL2 will have a positive polarity.

The gate driver 200 generates the gate high voltage VGH and the first gate low voltage VGL1 by using the first start pulse SP1 and the first clock signal CLK1 of the gate signal and the second gate low voltage VGL2 of the gate signal by using the second start pulse SP2 and the second clock signal CLK2. In other words, the gate driver 200 shifts the first start pulse SP1 according to the first clock signal CLK1 to generate the gate high voltages VGH and the first gate low voltages VGL1 required for the gate lines in succession. The gate driver 200 also shifts the second start pulse SP2 according to the second clock signal CLK2 to generate the second gate low voltages VGL2 required for the gate lines in succession. Accordingly, the gate high voltage VGH is generated at every rising edge of the first clock signal CLK1, and the second gate low voltage VGL2 is generated at every rising edge of the second clock signal CLK2.

The first and second start pulses SP1 and SP2 are provided only once within one frame period. That is, though the first and second clock signals CLK1 and CLK2 become active (a high state) many times periodically within one frame period, the first and second start pulses SP1 and SP2 become active only once within one frame period. The second start pulse SP2 is provided later than the first start pulse SP1, and the second start pulse SP2 has a pulse width greater than the first start pulse SP1. In the meantime, the first start pulse SP1 has a frequency two times greater than the second start pulse SP2.

The data driver 300 generates the data signal Data and supplies to the data line DL1 to DLm in response to data control signals which are not shown. In this instance, the data driver 300 supplies one horizontal portion of the data signal Data to each of the data lines DL1 to DLm in every horizontal period. The data signal Data may have a positive or negative polarity, and the present invention will be described based on a data signal Data having a positive polarity.

m pixel cells PXL on a horizontal line are connected to one gate line in common and to m data lines respectively. For an example, all of first to m(th) pixel cells PXL arranged along a first horizontal line HL1 are connected to the first gate line GL1 and the first to m(th) pixel cells PXL are connected to the first to m(th) data lines DL1 to DLm, respectively. In other words, the first pixel cell PXL of the first horizontal line HL1 is connected to the first data line DL1, the second pixel cell PXL of the first horizontal line HL1 is connected to the second data line DL2, the third pixel cell PXL of the first horizontal line HL1 is connected to the third data line DL3, ----, and the m(th) pixel cell PXL of the first horizontal line HL1 is connected to the m(th) data line DL2.

The first and second drive power lines and the control line are connected to all of the pixel cells PXL in common.

A structure of the pixel cell PXL will be described in more detail.

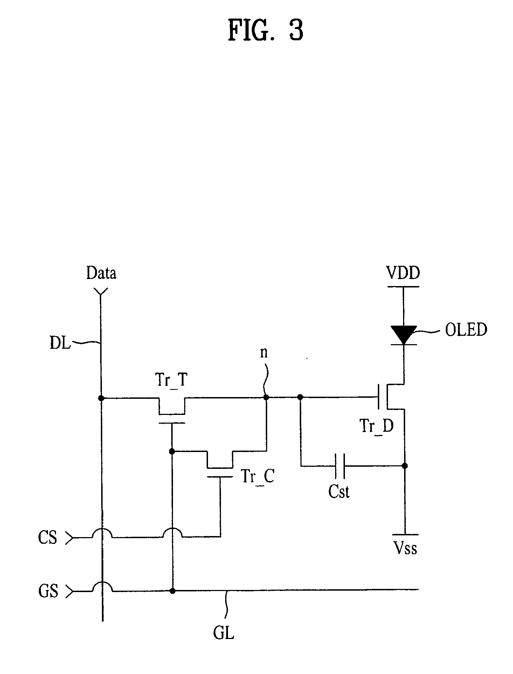

FIG. 3 illustrates a circuitry diagram of a pixel cell in FIG. 1.

Referring to FIG. 3, the pixel cell includes a light emitting diode OLED, a signal transmission switching device Tr_T, a drive switching device TR_D, a control switching device Tr_C, and a storage capacitor Cst.

The light emitting diode OLED for receiving a drive current controlled by the drive switching device Tr_D to emit the light, has a cathode connected to a drain electrode (or a source electrode) of the drive switching device Tr_D and an anode n connected to the first drive power line.

The signal transmission switching device Tr_T connects the data line to the node n in response to the first gate high voltage VGH from the gate line. For this, the signal transmission switching device Tr_T has a gate electrode connected to the gate line, a drain electrode (or a source electrode) connected to the data line DLm and a source electrode (or a drain electrode) connected to the node n.

The drive switching device Tr_D controls an intensity of the drive current supplied to the light emitting diode OLED according to a signal state of the node n. For this, the drive switching device Tr_D has a gate electrode connected to the node n, a drain electrode (or a source electrode) connected to a cathode of the light emitting diode OLED, and a source electrode (or a drain electrode) connected to the second power line which transmits second drive power.

The control switching device Tr_C connects the gate line to the node n in response to the second gate low voltage VGL2 from the gate line and the control signal CS from the control line. For this, the control switching device Tr_C has a gate electrode connected to the control line signal for transmission of the control signal CS, a drain electrode (or a source electrode) connected to a the node n, and a source electrode (or a drain electrode) connected to the gate line.

The control signal is a DC voltage having a value greater than a sum of the second gate low voltage VGL2 and the threshold voltage of the control switching device TR_C and smaller than the first gate low voltage VGL1. This can be expressed with an equation as follows.

$$VGL2+Vth(Tr\_C)<CS \leq VGL1 \quad ---------------------- \quad (1)$$

Where, Vth(Tr_C) denotes the threshold voltage of the control switching device Tr_C.

According to this, the control switching device Tr_C is turned on/off depending on a level of the gate signal supplied to the source electrode (an electrode connected to the gate line) of the control switching device Tr_C itself. That is, if the gate signal supplied to the source electrode is a level of the gate high voltage VGH or the first gate low voltage VGL1, a voltage between the gate electrode and the source electrode of the control switching device Tr_C, i.e., a gate-source electrode voltage has a level of a negative polarity. Therefore, if the gate signal supplied to the source electrode of the control switching device Tr_C is the level of the gate high voltage VGH or the first gate low voltage VGL1, the control switching device Tr_C is maintained at a turn off state. However, if the gate signal supplied to the source electrode of the control switching device Tr_C is a level of the second gate low voltage VGL1, the gate-source electrode voltage of the control switching device Tr_C has a level of a positive polarity. Therefore, if the gate signal supplied to the source electrode of the control switching device Tr_C is at the level of the second gate low voltage, the control switching device Tr_C is maintained at a turn on state.

If the control switching device Tr_C is turned on, the source electrode and the drain electrode of the control switching device Tr_C are connected to each other. That is, the gate line and the node n are connected to each other. Then, the node n becomes a negative polarity state by the second gate low voltage VGL2. Eventually, degradation of the drive switching device Tr_D is prevented, which is connected to the node n through the gate electrode.

The storage capacitor Cst, storing the data signal Data for one frame period, is connected between the node n and the source electrode of the drive switching device Tr_D, or the node n and the drain electrode.

The operation of the pixel cell PXL will be described.

Referring to FIGS. 2 and 3, as the gate signal is maintained at the gate high voltage VGH for a data input period T1, the signal transmission switching device Tr_T which receives the gate high voltage VGH through the gate electrode is turned on. According to this, the data signal Data is supplied from the data line DL to the node n through the signal transmission switching device Tr_T turned on thus. Then, the node n has a voltage elevated as much as the data signal Data, to turn on the drive switching device Tr_D which is connected to the node n through the gate electrode. Then, the drive current is generated through the drive switching device Tr_D turned on thus. The drive current is supplied to the light emitting diode OLED, staring to make the light emitting diode to emit the light. In the meantime, since the gate-source electrode voltage of the control switching device Tr_C has a negative polarity for the data input period T1, the control switching device Tr_C is maintained at a turn off state for the period T1.

Then, referring to FIGS. 2 and 3, as the gate signal is maintained at the first gate low voltage VGL1 for a light emission maintaining period T2, the signal transmission switching device Tr_T is turned off, which receives the first gate low voltage VGL1 through the gate electrode. According to this, the node n is floated, such that the node n floated thus has the data signal Data voltage which was supplied for the data input period T1 thereto maintained as it was. According to this, the drive switching device Tr_D is a turned on state for the period T2, and owing to the drive current from the drive switching device Tr_D in the turned on state, the light emitting diode OLED is maintained at a light emitting state. In the meantime, since the gate-source electrode voltage of the control switching device Tr_C has a negative polarity for the light emission maintaining period T2, the control switching device Tr_C is maintained at a turned off state for this period.

Then, as the gate signal is maintained at the second gate low voltage VGL2 for a restoring time period T3, the signal transmission switching device Tr_T which receives the second gate low voltage VGL2 through the gate electrode is maintained at a turn off state. As the gate-source electrode voltage of the control switching device Tr_C is turned to a positive polarity for the restoring period T3, the control switching device Tr_C is turned on for the period T3. Then, the second gate low voltage VGL2 is supplied from the gate line GL to the node n through the control switching device Tr_C turned on thus, causing the node n to discharge to the second gate low voltage VGL2. At the end, since a voltage of the node n drops from the positive polarity voltage of the data signal Data to a negative polarity voltage of the second gate low voltage VGL2, the degradation of the drive switching device Tr_D is prevented.

In order to make the foregoing operation, the gate driver 200 in the light emitting diode display device of the present invention has the following system.

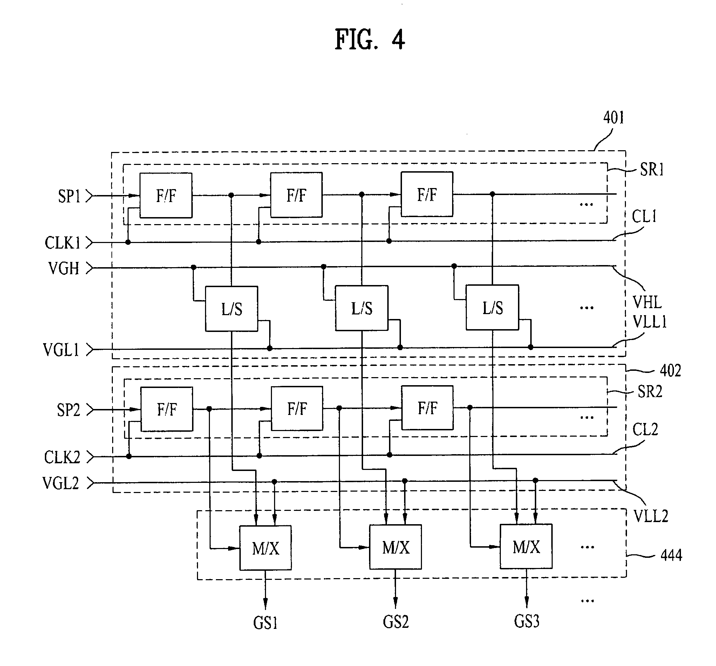

FIG. 4 illustrates a system diagram of a gate driver in accordance with a first preferred embodiment of the present invention.

Referring to FIG. 4, the gate driver includes a first driver 401, a second driver 402, and a selector 444.

The first driver 401 generates the gate high voltage VGH and the first gate low voltage VGL1 by using the first start pulse SP1 and the first clock signal CLK1 in succession for supplying to the gate lines, and the second driver 402 generates the second gate low voltage VGL2 by using the second start pulse SP2 and the second clock signal CLK2 in succession for supplying to the gate lines.

The selector 444 selects one of outputs from the first and second drivers 401 and 402 and forwards to the gate lines.

The first driver 401, the second driver 402, and the selector 444 will be described in more detail.

The first driver 401 includes a first shift register SR1 and a plurality of level shifters L/S.

The first shift register SR1 shifts the first start pulse SP1 according to the first clock signal CLK1, and forwards the first start pulse SP1 shifted thus in succession. The first shift register SR1 includes a plurality of flip-flops F/F connected to a first clock transmission line CL1 in common which transmits the first clock signal CLK1. A number of the flip-flops F/F are the same with a number of the gate lines. Each of the flip-flops F/F receives an output from a prior stage flip-flop as a start pulse, and shifts and forwards the output according to the first clock signal CLK1. Of the flip-flops F/F, the first flip-flop F/F positioned at the leftmost side on the drawing receives the first start pulse SP1 from an outside of the driver 401. An output from each of the flip-flops F/F is supplied to an input terminal of a next flip-flop and is used as an output from the first shifter SR1. According to this, an output is provided from the output terminals of the first shift register SR1 in succession, and the outputs provided in succession thus are supplied to respective level shifters L/S. A number of the level shifters L/S are the same with a number of the flip-flops F/F.

Each of the level shifters L/S selects and forwards one of the gate high voltage VGH and the first gate low voltage VGL1 depending on logics of the outputs from the first shift register SR1. The level shifters L/S are connected to a high voltage transmission line VHL which transmits the gate high voltage VGH and a first low voltage transmission line VLL1 which transmits the first gate low voltage VGL1 in common. That is, if the output from any one of output terminals of the first shift register SR1 is at high logic, any one of the level shifters L/S selects and forwards the gate high voltage VGH. Opposite to this, if the output from any one of output terminals of the first shift register SR1 is at low logic, any one of the level shifters L/S selects and forwards the first low gate voltage VGL1.

The second driver 402 includes a second shift register SR2 and a low power generating unit.

The second shift register SR2 shifts the second start pulse SP2 according to the second clock signal CLK2, and forwards the second start pulse SP2 shifted thus in succession. The second shift register SR2 includes a plurality of flip-flops F/F connected to a second clock transmission line CL2 in common, which transmits the second clock signal CLK2. A number of the flip-flops F/F are the same with a number of the gate lines. Each of the flip-flops F/F receives an output from a prior stage flip-flop as a start pulse, and shifts and forwards the output according to the second clock signal CLK2. Of the flip-flops F/F, the first flip-flop F/F positioned at the leftmost side on the drawing receives the second start pulse SP2 from an outside of the driver 402. An output from each of the flip-flops F/F is supplied to an input terminal of a next flip-flop and is used as an output from the second shifter SR2. According to this, an output is provided from the output terminals of the second shift register SR2 in succession, and the outputs provided in succession thus are supplied to respective level shifters L/S. A number of the level shifters L/S are the same with a number of the flip-flops F/F.

The low power generating unit generates the second gate low voltage VGL2. The second gate low voltage VGL2 is supplied to the second low voltage transmission line VLL2.

The selector 444 includes a plurality of multiplexers M/X in correspondence to the level shifters L/S. Each of the multiplexers M/X selects one from the output from the level shifter L/S and the output from the second low voltage transmission line depending on logic of an output from the second shift register SR2. That is, each of the multiplexers M/X selects the gate high voltage VGH or the first gate low voltage VGL1 from the level shifters L/S when the output from the second shift register SR2 is at low logic, and the second gate low voltage VGL2 from the low power generating unit when the output from the second shift register SR2 is at high logic.

According to a structure of the gate driver 200 in accordance with the first preferred embodiment of the present invention, the first shift register SR1 generates outputs in succession in response to the first start pulse SP1 at first, and after generation of the specific outputs of the first shift register SR1, the second shift register SR2 starts to generates the outputs in succession following the generation of the second start pulse SP2. In other words, the outputs from the output terminals of the first shift register SR1 are provided before the outputs from the output terminals of the second shift register SR2, respectively.

In this instance, each of the multiplexers M/X receives an output from the first shift register passed through the level shifter L/S and the second gate low voltage VGL2 from the second low power transmission line, and selects and forwards the gate high voltage VGH and the first gate low voltage VGL1 in succession if the output of the second shift register SR2, i.e., the output from the flip-flop F/F of the second shift register SR2 is at low logic. Then, the multiplexer M/X selects and forwards the second gate low voltage VGL2 in succession if the output of the second shift register SR2, i.e., the output from the flip-flop F/F of the second shift register SR2 is at high logic. According to this, the gate signals from one of the multiplexers M/X have levels of the gate high voltage VGH, the gate low voltage VGL1, and the second gate low voltage VGL2 in a sequence. In this instance, the gate high voltage VGH is provided for the data input period T1, the first gate low voltage VGL1 is provided for the light emission maintaining period T2, and the second gate low voltage VGL2 is provided for the restoring period T3. In the meantime, the output after the restoring period T3 has a level of the first gate low voltage VGL1.

In this instance, one output from one multiplexer is supplied to one gate line. That is, the output terminal of a k(th) multiplexer M/X is connected to a k(th) gate line (k is a natural numeral).

The gate driver 200 of the present invention may have the following system.

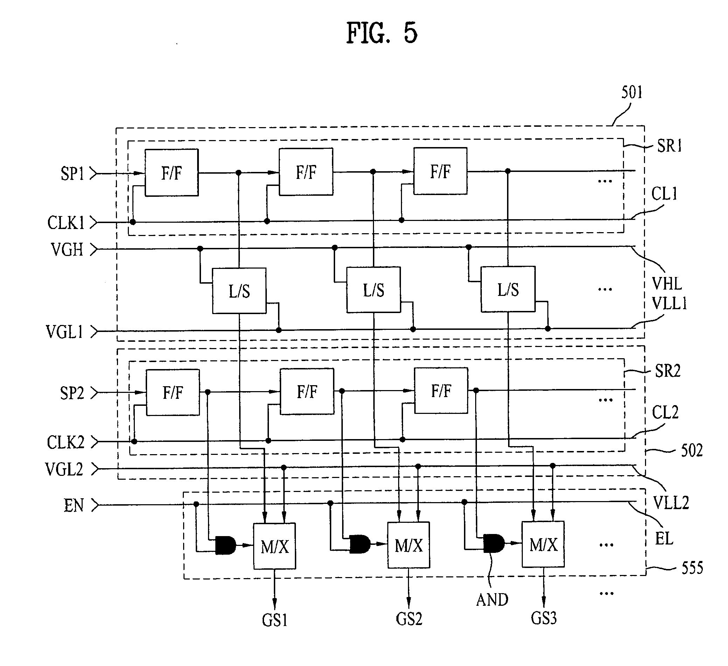

FIG. 5 illustrates a system diagram of a gate driver in accordance with a second preferred embodiment of the present invention.

Referring to FIG. 5, the gate driver 200 includes a first driver 501, a second driver 502, and a selector 555. Since the first and second drivers 501 and 502 are identical to the first and second drivers 401 and 402, description of which will be omitted.

The selector 555 includes a plurality of multiplexers M/X corresponding to the level shifter L/S, a plurality of logic sum gates AND for making logical operation of the outputs from the second shift register SR2 and an external enable signal EN. The enable signal EN is transmitted through an enable transmission line EL.

The multiplexers M/X select the gate high voltages VGH or the first gate low voltages VGL1 from the level shifters L/S respectively when an output from the logic sum gate AND is at low logic, and the second gate low voltages VGL2 from the low power generating unit respectively when the output from the logic sum gate AND is at high logic. The enable signal EN is maintained at the low logic for a period the gate high voltage VGH and the first gate low voltage VGL1 are applied to every one of the gate lines GL1 to GLn once, and is maintained at the high logic in a period thereafter. That is, the enable signal EN and the logic sum gate AND prevents the second gate low voltage VGL2 from supplying to the gate lines GL1 to GLn for the period in which the gate high voltages VGH and the first gate low voltages VGL1 are supplied to the gate lines from the first driver 501. Of course, alike the first embodiment, though the supply of the second gate low voltage VGL2 to the gate lines GL1 to GLn for above period can be prevented by making the first and second start pulses SP1 and SP2 to be provided in periods different from each other even without the enable signal EN and the logic sum gate AND additionally, the addition of the enable signal EN and the logic sum gate AND permits to prevent malfunction liable to cause by distortion of a signal, positively.

As has been described, the light emitting display device of the present invention has the following advantages.

The supply of a voltage having a polarity opposite to a data signal to a gate electrode of the drive switching device in each period, restoring a threshold voltage of the drive switching device to an original value, prevents the drive switching device from degrading.

**Claims**

1. A light emitting diode display device comprising:

   a plurality of pixel cells (PXL) each having a light emitting diode (OLED);
   a plurality of data lines (DL1, DL2, DL3, ..., DLm);
   a data driver (300) adapted to supply a data signal (Data) having information on a picture to the data lines (DL1, DL2, DL3, ..., DLm);
   a plurality of gate lines (GL1, GL2, ..., GLn-1, GLn);
   a gate driver (200) adapted to drive the plurality of gate lines (GL1, GL2, ..., GLn-1, GLn)), wherein the gate driver (200) is adapted to generate a gate signal (GS) having a gate high voltage (VGH), a first gate low voltage (VGL1), and a second gate low voltage (VGL2), wherein the gate high voltage (VGH), the first gate low voltage (VGL1) and the second gate low voltage (VGL2) have potentials different from one another, and wherein the second gate low voltage (VGL2) has a polarity opposite to the data signal (Data);
   a control line (CS);
   wherein each of the pixel cells (PXL) includes:

      a signal transmission switching device (Tr_T) adapted to connect the data line (DL) to a node (n) according to the gate signal (GS), the data line (DL) being connected to the node (n) when the gate signal (GS) has the gate high voltage (VGH) and disconnected when the gate signal (GS) has the first or second gate low voltage (VGL1, VGL2),
      a drive switching device (Tr_D) adapted to control an intensity of a drive current being supplied to the light emitting diode (OLED) according to a potential of the node (n),
      a storage capacitor (Cst) connected between the node (n) and a source electrode or a drain electrode of the drive switching device (Tr_D), and
      a control switching device (Tr_C) adapted to connect the gate line (GL) to the node (n) in response to a control signal (CS) from the control line, wherein the control switching device (Tr_C) has a gate electrode connected to the control line, a first terminal connected to the node (n) and a second terminal connected to the gate line (GL);
      wherein the display device is adapted to apply the control signal (CS) to the control line, said control signal (CS) being a DC voltage higher than a sum of the second gate low voltage (VGL2) and a threshold voltage of the control switching device (Tr_C), and lower than the first gate low voltage (VGL1); and
      wherein the data driver (300) and the gate driver (200) are further adapted to perform the following steps:

         - during a data input period (T1), the gate signal (GS) is maintained at the gate high voltage (VGH) and the data signal (Data) is applied and consequently the data signal (Data) is supplied to the node (n), then
         - during a light emission maintaining period (T2), the gate signal (GS) is maintained at the first gate low voltage (VGL1) and consequently the data signal (Data) supplied to the node (n) is maintained, then
         - during a restoring period (T3), the gate signal (GS) is maintained at the second gate low voltage (VGL2) and consequently the second gate low voltage (VGL2) is supplied to the node (n).

2. The device as claimed in claim 1, wherein the gate driver (200) is adapted to generate the first gate low voltage (VGL1) and the second gate low voltage (VGL2) such that the first gate low voltage (VGL1) is lower than the gate high voltage (VGH), and that the second gate low voltage (VGL2) is lower than the first gate low voltage (VGL1).

3. The device as claimed in claim 2,
   wherein the gate driver (200) includes:

      a first driver (401) adapted to generate the gate high voltage (VGH) and the first gate low voltage (VGL1) in succession by using a first start pulse (SP1) and a first clock signal (CLK1) for supplying to the gate lines (GL1, GL2, ..., GLn-1, GLn),
a second driver (402) adapted to provide the second gate low voltage (VGL2) in succession by using a second start pulse (SP2) having a pulse width greater than the first start pulse (SP1) and provided later than the first start pulse (SP1) and a second clock signal (CLK2) having a pulse width greater than the first clock signal (CLK1) for supplying to the gate lines (GL1, GL2, ..., GLn-1, GLn), wherein the second clock signal (CLK2) has a frequency lower than the first clock signal (CLK1), and
a selector (444) adapted to select one from outputs of the first and second drivers (401, 402) and to forward the output selected thus to the gate lines (GL1, GL2, ..., GLn-1, GLn).

4.  The device as claimed in claim 3, wherein the first driver (401) includes a first shift register (SR1) adapted to shift the first start pulse (SP1) according to the first clock signal (CLK1) and to forward the first start pulse (SP1) shifted thus in succession, and a plurality of level shifters (L/S) adapted to select one from the gate high voltage (VGH) and the first gate low voltage (VGL1) depending on logic of forwarding from the first shift register (SR1), and to forward the one selected thus in succession,
the second driver (402) includes a second shift register (SR2) adapted to shift and forward the second start pulse (SP2) according to the second clock signal (CLK2) in succession, and a low power generating unit adapted to generate the second gate low voltage (VGL2), and
the selector (444) includes a plurality of multiplexers (M/X) corresponding to the level shifters (L/X), wherein the multiplexers (M/X) are adapted to select the gate high voltage (VGH) or the first gate low voltage (VGL1) from the level shifters (L/X) respectively at the time an output from the second shift register (SR2) is at low logic, and the second gate low voltage (VGL2) from the low power generating unit at the time an output from the second shift register (SR2) is at high logic.

5.  The device as claimed in claim 3, wherein the first driver (401) includes a first shift register (SR1) adapted to shift and forward the first start pulse (SP1) according to the first clock signal (CLK1) in succession, and a plurality of level shifters (L/X) adapted to select one from the gate high voltage (VGH) and the first gate low voltage (VGL1) depending on logic of outputs from the first shift register (SR1) and to forward the one selected thus,
the second driver (402) includes a second shift register (SR2) adapted to shift and to forward the second start pulse (SP2) according to the second clock signal (CLK2) in succession, and a low power generating unit adapted to generate the second gate low voltage (VGL2), and
the selector (444) includes a plurality of multiplexers (M/X) corresponding to the level shifters (L/X) and a plurality of logic sum gates (AND) adapted to make logical operation of the outputs from the second shift register (SR2) and an external enable signal (EN), wherein the multiplexers (M/X) are adapted to select the gate high voltage (VGH) or the first gate low voltage (VGL1) from the level shifters (L/X) respectively at the time an output of the logical sum gate (AND) is at low logic, and the second gate low voltage (VGL2) from the low power generating unit at the time the output from the logical sum gate (AND) is at high logic.

**Patentansprüche**

1.  Leuchtdioden-Anzeigevorrichtung aufweisend:

    eine Mehrzahl von Bildpunktzellen (PXL), wobei jede Bildpunktzelle eine lichtemittierende Diode (OLED) aufweist;
    eine Mehrzahl von
    Datenleitungen (DL1, DL2, DL3, , DLm);
    einen Datentreiber (300), eingerichtet zum Bereitstellen eines Datensignals (Data), das Information über ein Bild aufweist, an die Datenleitungen (DL1, DL2, DL3, ..., DLm);
    eine Mehrzahl von Gate-Leitungen (GL1, GL2, ..., GLn-1, GLn);
    einen Gate-Treiber (200), eingerichtet, die Mehrzahl von Gate-Leitungen (GL1, GL2, ..., GLn-1, GLn) anzutreiben,
    wobei der Gate-Treiber (200) derart eingerichtet ist,
    dass er ein Gate-Signal (GS) erzeugt mit einer Gate-Hochspannung (VGH), einer ersten Gate-Niederspannung (VGL1) und einer zweiten Gate-Niederspannung (VGL2), wobei die Gate-Hochspannung (VGH), die erste Gate-Niederspannung (VGL1) und die zweite Gate-Niederspannung (VGL2) voneinander unterschiedliche Potentiale aufweisen und wobei die zweite Gate-Niederspannung (VGL2) eine dem Datensignal (Data) entgegengesetzte Polarität aufweist;
    eine Steuerleitung (CS);

wobei jede der Bildpunktzellen (PXL) aufweist:

• eine Signalübertragungs-Schaltvorrichtung (Tr_T), eingerichtet, die Datenleitung (DL) mit einem Netzwerkknoten (n) gemäß dem Gate-Signal (GS) zu verbinden; wobei die Datenleitung (DL) mit dem Netzwerkknoten (n) verbunden ist, wenn das Gate-Signal (GS) die Gate-Hochspannung (VGH) aufweist und die unterbrochen ist, wenn das Gate-Signal (GS) die erste oder die zweite Gate-Niederspannung (VGL1, VG12) aufweist;

• eine Treiberschaltvorrichtung (Tr_D), eingerichtet, eine Intensität eines Treiberstroms zu steuern, der an die lichtemittierende Diode (OLED) gemäß einem Potential des Netzwerkknotens (n) geliefert wird;

• einen Speicherkondensator (Cst), der zwischen dem Netzwerkknoten (n) und einer Source-Elektrode oder einer Drain-Elektrode der Treiberschaltvorrichtung (Tr_D) angeschlossen ist; und

• eine Steuerschaltvorrichtung (Tr_C), eingerichtet, die Gate-Leitung (GL) mit dem Netzwerkknoten (n) in Antwort auf ein Steuersignal (CS) von der Steuerleitung zu verbinden, wobei die Steuerschaltvorrichtung (Tr_C) eine Gate-Elektrode, die mit der Steuerleitung verbunden ist, einen erste Anschluss, der mit dem Netzwerkknoten (n) verbunden ist und einen zweiten Anschluss, der mit der Gate-Leitung (GL) verbunden ist, aufweist;

• wobei die Anzeigevorrichtung derart eingerichtet ist, dass sie das Steuersignal (CS) an die Steuerleitung anlegt, wobei das Steuersignal (CS) eine DC Spannung ist, die höher ist als eine Summe der zweiten Gate-Niederspannung (VGL2) und einer Schwellenspannung der Steuerschaltvorrichtung (Tr_C) und niedriger ist als die erste Gate-Niederspannung (VGL1); und

• wobei der Datentreiber (300) und der Gate-Treiber (200) ferner eingerichtet zum Ausführen der folgenden Schritte:

- während eines Dateneingabezeitraums (T1) wird das Gate-Signal (GS) bei der Gate-Hochspannung (VGH) beibehalten und das Datensignal (Data) wird angelegt und folglich wird das Datensignal (Data) an den Netzwerkknoten (n) geliefert.

- während eines Lichtemissions-Aufrechterhaltungs-Zeitraums (T2), wird das Gate-Signal (GS) bei der ersten Gate-Niederspannung (VGL1) beibehalten und folglich wird das an den Netzwerkknoten (n) gelieferte Datensignal (Data) aufrechterhalten; danach

- wird während eines Wiederherstellungszeitraums (T3) das Gate-Signal (GS) bei der zweiten Gate-Niederspannung (VGL2) beibehalten und folglich wird die zweite Gate-Niederspannung (VGL2) an den Netzwerkknoten (n) geliefert.

**2.** Vorrichtung wie beansprucht in Anspruch 1,
wobei der Gate-Treiber (200) derart eingerichtet ist, dass er die erste Gate-Niederspannung (VGL1) und die zweite Gate-Niederspannung (VGL2) erzeugt, so dass die erste Gate-Niederspannung (VGL1) geringer ist als die Gate-Hochspannung (VGH) und so dass die zweite Gate-Niederspannung (VGL2) geringer ist als die erste Gate-Niederspannung (VGL1).

**3.** Vorrichtung wie beansprucht in Anspruch 2,
wobei der Gate-Treiber (200) aufweist:

• einen ersten Treiber (401), eingerichtet, in Folge die Gate-Hochspannung (VGH) und die erste Gate-Niederspannung (VGL1) mittels Verwendens von einem ersten Startimpuls (SP1) und einem ersten Taktsignals (CLK1) zu erzeugen, zum Versorgen der Gate-Leitungen (GL1, GL2, ..., GLn-1, GLn)

• einen zweiten Treiber (402), derart eingerichtet, dass er in Folge die zweite Gate-Niederspannung (VGL2) mittels Verwendens von einem zweiten Startimpuls (SP2) mit einer größeren Impulsbreite als der erste Startimpuls (SP1) und bereitgestellt später als der erste Startimpuls (SP1) und einem zweiten Taktsignal (CLK2) mit einer größeren Impulsbreite als das erste Taktsignal (CLK1) bereitstellt, zum Versorgen der Gate-Leitungen (GL1, GL2, ..., GLn-1, GLn), wobei das zweite Taktsignal (CLK2) eine Frequenz aufweist, die geringer ist als die des ersten Taktsignals (CLK1); und

• einen Selektierer (444), eingerichtet, eine von den Ausgaben des ersten oder des zweiten Treibers (401, 402) auszuwählen und so dass er die ausgewählte Ausgabe an die Gate-Leitungen (GL1, GL2, ..., GLn-1, GLn) weiterleitet.

**4.** Vorrichtung wie beansprucht in Anspruch 3,

• wobei der erste Treiber (401) ein erstes Schieberegister (SR1) aufweist, eingerichtet, den ersten Startimpuls (SP1) gemäß des ersten Taktsignals (CLK1) zu verschieben und den ersten somit in Folge verschobenen Startimpuls (SP1) weiterzuleiten, sowie eine Mehrzahl von Pegelwandlern (L/S), eingerichtet, eine der Gate-Hochspannung (VGH) und der Gate-Niederspannung (VGL1) auszuwählen, abhängig von einer Logik des Weiterleitens von dem ersten Schieberegister (SR1), und eingerichtet, die Ausgewählte somit in Folge weiterzuleiten;

• wobei der zweite Treiber (402) ein zweites Schieberegister (SR2) aufweist, eingerichtet, den zweiten Startimpuls (SP2) gemäß dem zweiten Taktsignal (CLK2) in Folge zu verschieben und weiterzuleiten und eine Niederenergieerzeugungseinheit, eingerichtet, die zweite Gate-Niederspannung (VGL2) zu erzeugen; und

• wobei der Selektierer (444) eine Mehrzahl von Multiplexern (M/X), zugehörig zu den Pegelwandlern (L/X), aufweist, wobei die Multiplexer (M/X) derart eingerichtet sind, dass die Gate-Hochspannung (VGH) oder die erste Gate-Niederspannung (VGL1) von den jeweiligen Pegelwandlern (L/X) ausgewählt werden, zu dem Zeitpunkt einer Ausgabe des zweiten Schieberegisters (SR2), zu dem diese bei einem Niedrig-Pegel ist und die zweite Gate-Niederspannung (VGL2) der Niederenergieerzeugungseinheit zu einem Zeitpunkt einer Ausgabe des zweiten Schieberegisters (SR2), zu dem diese bei einem Hoch-Pegel ist.

5. Vorrichtung wie beansprucht in Anspruch 3,

• wobei der erste Treiber (401) ein erstes Schieberegister (SR1) aufweist, eingerichtet den ersten Startimpulses (SP1) gemäß dem ersten Taktsignal (CLK1) in Folge zu verschieben und weiterzuleiten und eine Mehrzahl von Pegelwandlern (L/X), eingerichtet, eine der Gate-Hochspannung (VGH) und der ersten Gate-Niederspannung (VGL1) auszuwählen, abhängig von einer Logik der Ausgaben von dem ersten Schieberegister (SR1), und eingerichtet, die eine Ausgewählte somit weiterzuleiten;

• wobei der zweite Treiber (402) ein zweites Schieberegister (SR2) aufweist, eingerichtet, den zweiten Startimpuls (SP2) gemäß dem zweiten Taktsignal (CLK2) in Folge zu verschieben und weiterzuleiten und eine Niederenergieerzeugungseinheit, eingerichtet, die zweite Gate-Niederspannung (VGL2) zu erzeugen; und

• wobei der Selektierer (444) eine Mehrzahl von Multiplexern (M/X), zugehörig zu den Pegelwandlern (L/X) aufweist, und eine Mehrzahl von Logik-Addier-Gattern (AND), eingerichtet, eine Logikoperation der Ausgaben des zweiten Schieberegisters (SR2) und eines externen Freigabesignals (EN) durchzuführen, wobei die Multiplexer (M/X) eingerichtet sind, die Gate-Hochspannung (VGH) oder die erste Gate-Niederspannung (VGL1) des jeweiligen Pegelwandlers (L/X) auszuwählen, zu dem Zeitpunkt einer Ausgabe des Logik-Addier-Gatters (AND), zu der diese bei einem Niedrig-Pegel ist und die zweite Gate-Niederspannung (VGL2) der Niederenergieerzeugungseinheit, zu einem Zeitpunkt der Ausgabe des Logik-Addier-Gatters (AND), zu der diese bei einem Hoch-Pegel ist.

**Revendications**

1. Dispositif d'affichage à diodes électroluminescentes comprenant :

une pluralité de cellules de pixels (PXL), chacune d'elles présentant une diode électroluminescente (OLED) ;
une pluralité de lignes de données (DL1, DL2, DL3, ..., DLm) ;
un dispositif de commande de données (300) adapté pour fournir aux lignes de données (DL1, DL2, DL3, ... , DLm) un signal de données (Data) présentant des informations se rapportant à une image ;
une pluralité de lignes de grilles (GL1, GL2, ... , GLn-1, GLn) ;
un dispositif de commande de grille (200) adapté pour commander la pluralité de lignes de grilles (GL1, GL2, ... , GLn-1, GLn), dans lequel le dispositif de commande de grille (200) est adapté pour générer un signal de grille (GS) présentant une tension élevée de grille (VGH), une première tension basse de grille (VGL1), et une seconde tension basse de grille (VGL2), dans lequel la tension élevée de grille (VGH), la première tension basse de grille (VGL1) et la seconde tension basse de grille (VGL2) présentent des potentiels différents les uns des autres, et dans lequel la seconde tension basse de grille (VGL2) présente une polarité opposée au signal de données (Data) ;
une ligne de commande (CS) ;
dans lequel chacune des cellules de pixels (PXL) comprend :

un dispositif de commutation de transmission de signal (Tr_T) adapté pour connecter la ligne de données (DL) à un noeud (n) selon le signal de grille (GS), la ligne de données (DL) étant connectée au noeud (n) lorsque le signal de grille (GS) présente la tension élevée de grille (VGH), et étant déconnectée lorsque le signal de grille (GS) présente la première ou la seconde tension basse de grille (VGL1, VGL2) ;

un dispositif de commutation de commande (Tr_D) adapté pour commander l'intensité d'un courant de commande fourni à la diode électroluminescente (OLED) selon le potentiel du noeud (n) ;

un condensateur de stockage (Cst) connecté entre le noeud (n) et une électrode de source ou une électrode de drain du dispositif de commutation de commande (Tr_D) ; et

un dispositif de commutation de commande (Tr_C) adapté pour connecter la ligne de grille (GL) au noeud (n) en réponse à un signal de commande (CS) en provenance de la ligne de commande, dans lequel le dispositif de commutation de commande (Tr_C) présente une électrode de grille connectée à la ligne de commande, une première borne connectée au noeud (n) et une seconde borne connectée à la ligne de grille (GL) ;

dans lequel le dispositif d'affichage est adapté pour appliquer le signal de commande (CS) à la ligne de commande, ledit signal de commande (CS) étant une tension à courant continu supérieure à la somme de la seconde tension basse de grille (VGL2) et d'une tension de seuil du dispositif de commutation de commande (Tr_C), et inférieure à la première tension basse de grille (VGL1) ; et

dans lequel le dispositif de commande de données (300) et le dispositif de commande de grille (200) sont en outre adaptés pour exécuter les étapes suivantes :

- au cours d'une période d'entrée de données (T1), le signal de grille (GS) est maintenu à la tension élevée de grille (VGH) et le signal de données (Data) est appliqué et par conséquent le signal de données (Data) est fourni au noeud (n) ; puis
- au cours d'une période de maintien d'émission de lumière (T2), le signal de grille (GS) est maintenu à la première tension basse de grille (VGL1) et par conséquent le signal de données (Data) fourni au noeud (n) est maintenu ; puis
- au cours d'une période de restauration (T3), le signal de grille (GS) est maintenu à la seconde tension basse de grille (VGL2) et par conséquent la seconde tension basse de grille (VGL2) est fournie au noeud (n).

2. Dispositif selon la revendication 1, dans lequel le dispositif de commande de grille (200) est adapté pour générer la première tension basse de grille (VGL1) et la seconde tension basse de grille (VGL2) de telle sorte que la première tension basse de grille (VGL1) soit inférieure à la tension élevée de grille (VGH), et que la seconde tension basse de grille (VGL2) soit inférieure à la première tension basse de grille (VGL1).

3. Dispositif selon la revendication 2, dans lequel le dispositif de commande de grille (200) comprend :

un premier dispositif de commande (401) adapté pour générer la tension élevée de grille (VGH) et la première tension basse de grille (VGL1) à la suite en utilisant une première impulsion de début (SP1) et un premier signal d'horloge (CLK1) à fournir aux lignes de grilles (GL1, GL2, ... , GLn-1, GLn) ;

un second dispositif de commande (402) adapté pour fournir la seconde tension basse de grille (VGL2) à la suite en utilisant une seconde impulsion de début (SP2) présentant une largeur d'impulsion supérieure à la première impulsion de début (SP1) et fournie plus tard que la première impulsion de début (SP1), et un second signal d'horloge (CLK2) présentant une largeur d'impulsion supérieure au premier signal d'horloge (CLK1) à fournir aux lignes de grilles (GL1, GL2, ... , GLn-1, GLn), dans lequel le second signal d'horloge (CLK2) présente une fréquence inférieure au premier signal d'horloge (CLK1); et

un dispositif de sélection (444) adapté pour sélectionner l'une des sorties des premier et second dispositifs de commande (401, 402) et pour transmettre la sortie ainsi sélectionnée aux lignes de grilles (GL1, GL2, ... , GLn-1, GLn).

4. Dispositif selon la revendication 3, dans lequel le premier dispositif de commande (401) comprend un premier registre à décalage (SR1) adapté pour décaler la première impulsion de début (SP1) selon le premier signal d'horloge (CLK1) et pour transmettre la première impulsion de début (SP1) ainsi décalée à la suite, et une pluralité de dispositifs de décalage de niveau (L/S) adaptés pour sélectionner l'une de la tension élevée de grille (VGH) et de la première tension basse de grille (VGL1) selon le niveau logique de transmission à partir du premier registre à décalage (SR1), et pour expédier celle qui a été ainsi sélectionnée à la suite;

le second dispositif de commande (402) comprend un second registre à décalage (SR2) adapté pour décaler et transmettre la seconde impulsion de début (SP2) selon le second signal d'horloge (CLK2) à la suite, et une unité de génération de tension basse adaptée pour générer la seconde tension basse de grille (VGL2) ; et

le dispositif de sélection (444) comprend une pluralité de multiplexeurs (M/X) correspondant aux dispositifs de décalage de niveau (L/X), dans lequel les multiplexeurs (M/X) sont adaptés pour sélectionner la tension élevée de grille (VGH) ou la première tension basse de grille (VGL1) en provenance des dispositifs de décalage de niveau (L/X) respectivement au moment où la sortie en provenance du second registre à décalage (SR2) se trouve à un niveau logique bas, et la seconde tension basse de grille (VGL2) en provenance de l'unité de génération de tension basse au moment où la sortie en provenance du second registre à décalage (SR2) se trouve à un niveau logique haut.

5. Dispositif selon la revendication 3, dans lequel le premier dispositif de commande (401) comprend un premier registre à décalage (SR1) adapté pour décaler et transmettre la première impulsion de début (SP1) selon le premier signal d'horloge (CLK1) à la suite, et une pluralité de dispositifs de décalage de niveau (L/X) adaptés pour sélectionner l'une de la tension élevée de grille (VGH) et de la première tension basse de grille (VGL1) selon le niveau logique des sorties en provenance du premier registre à décalage (SR1), et pour transmettre celle qui a été ainsi sélectionnée ;

le second dispositif de commande (402) comprend un second registre à décalage (SR2) adapté pour décaler et transmettre la seconde impulsion de début (SP2) selon le second signal d'horloge (CLK2) à la suite, et une unité de génération de tension basse adaptée pour générer la seconde tension basse de grille (VGL2) ; et

le dispositif de sélection (444) comprend une pluralité de multiplexeurs (M/X) correspondant aux dispositifs de décalage de niveau (L/X) et une pluralité de portes de sommation logique (AND) adaptées pour exécuter une opération logique sur les sorties en provenance du second registre à décalage (SR2) et sur un signal de validation extérieur (EN), dans lequel les multiplexeurs (M/X) sont adaptés pour sélectionner la tension élevée de grille (VGH) ou la première tension basse de grille (VGL1) en provenance des dispositifs de décalage de niveau (L/X) respectivement au moment où la sortie de la porte de sommation logique (AND) se trouve à un niveau logique bas, et la seconde tension basse de grille (VGL2) en provenance de l'unité de génération de tension basse au moment où la sortie de la porte de sommation logique (AND) se trouve à un niveau logique haut.

# FIG. 1

# FIG. 2

EP 2 144 222 B1

# FIG. 3

# FIG. 4

EP 2 144 222 B1

# FIG. 5

EP 2 144 222 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• US 2004257353 A1